# EUROPÄISCHE PATENTSCHRIFT

(11) **EP 3 159 618 B1**
(45) Veröffentlichungstag und Bekanntmachung des Hinweises auf die Patenterteilung: **29.06.2022**
(21) Anmeldenummer: 16165510.5
(22) Anmeldetag: 15.04.2016
(51) Int. Cl.: F24F 3/044, F24F 11/00, H05K 7/20, F24F 12/00

(54) **UMSCHALT- UND MISCHEINRICHTUNG, RAUMLUFTTECHNISCHE ANLAGE SOWIE AUSLEGUNGSVERFAHREN EINER RAUMLUFTTECHNISCHEN ANLAGE**
SWITCHING AND MIXING DEVICE, INDOOR AIR TREATMENT SYSTEM AND DESIGN METHOD FOR AN INDOOR AIR TREATMENT SYSTEM
DISPOSITIF DE COMMUTATION ET DE MÉLANGE, INSTALLATION DE CLIMATISATION ET MÉTHODE DE CONCEPTION D'UNE INSTALLATION DE CLIMATISATION

(30) Priorität: 21.10.2015 DE 102015013641; 30.12.2015 EP 15203181
(43) Veröffentlichungstag der Anmeldung: 26.04.2017
(73) Patentinhaber: Howatherm Klimatechnik GmbH, 55767 Brücken (DE)
(72) Erfinder: Kaup, Christoph, 55767 Brücken (DE)
(74) Vertreter: Westphal, Mussgnug & Partner Patentanwälte mbB

(56) Entgegenhaltungen:
- WO-A1-2009/156146
- DE-A1- 10 126 475
- DE-A1-102004 049 621
- DE-U1-202010 008 740

## Beschreibung

Die Erfindung betrifft eine Umschalt- und Mischeinrichtung, insbesondere für eine raumlufttechnische Anlage, beispielsweise eine raumlufttechnische Anlage mit einem Trennflächen-Wärmeübertrager für ein Rechenzentrum oder einem sonstigen thermisch hochbelasteten Raum, sowie eine raumlufttechnische Anlage mit einer solchen Umschalt- und Mischeinrichtung. Die Umschalt- und Mischeinrichtung kann in einem Anlagenbereich zwischen Luftanschlüssen auf der einen Seite und einem Wärmeübertrager auf der anderen Seite angeordnet sein.

Die Erfindung betrifft ferner ein Auslegungsverfahren einer raumlufttechnischen Anlage mit einer solchen Umschalt- und Mischeinrichtung.

Bekannte Trennflächen-Wärmeübertrager, wie beispielsweise aus DE 101 26 475 A1, WO 2009/156146 A1, DE 10 2004 049 621 A1 oder DE 20 2010 008 740 U1 bekannt, übertragen bevorzugt sensible Wärme. Fluidströme unterschiedlicher Temperatur sind durch dünne Platten voneinander getrennt, beispielsweise Platten aus Aluminium, Edelstahl oder Kunststoff. Die Anordnung der Wärmeübertrager beschäftigt Entwickler seit Jahrzehnten. Dabei ist nach den üblichen Merkmalen der Systeme zur Wärmerückgewinnung aus VDI 3803 Blatt 5 für Plattenwärmeübertrager ein mittlerer Platzbedarf zu berücksichtigen. Weiterhin ist es bekannt, dass in einer raumlufttechnischen Anlage mehrere Trennflächen-Wärmeübertrager hintereinander geschaltet werden können. Plattenwärmeübertrager werden bei dieser Schaltung bisher immer derart angeordnet, dass ihre Anströmseiten der Platten einander zugewandt sind. Aber auch Neuentwicklungen, die Plattenwärmeübertrager völlig neuartig anordnen, beispielsweise in einem geschlossenen Strömungsumkehrende, beschäftigen sich häufig nur mit der Anzahl von Verbindungsströmungswegen und deren Druckverlusten. Solche Anlagen sind strömungstechnisch noch deutlich verbesserbar. Zur Lösung dieses Problems betrifft die Erfindung eine Umschalt- und Mischeinrichtung nach Anspruch 1, ein Auslegungsverfahren nach Anspruch 9 und eine raumlufttechnische Anlage nach Anspruch 10. Dabei schlägt die Erfindung eine Verwendung eines Wärmeübertragers als Umlenkkammer vor.

Vorteilhafte Ausführungsformen sind in den jeweiligen abhängigen Ansprüchen angegeben. Die als ein Anwendungsbeispiel oben erwähnte raumlufttechnische Anlage mit der erfindungsgemäßen Umschalt- und Mischeinrichtung baut sehr kompakt und erreicht hohe Wirkungsgrade, insbesondere bei der Nutzung der indirekten Verdunstungskühlung, sodass im Ergebnis unter üblichen Bedingungen auf zusätzliche mechanische Kühlungsgeräte verzichtet werden kann, unter denen bisher zwangsweise solche in der Anschaffung und Unterhaltung recht teure Kühlungsgeräte meist als unverzichtbar gelten. Die dargestellte raumlufttechnische Anlage wird auch zur näheren Beschreibung einer erfindungsgemäßen Verwendung eines Wärmeübertragers als Umlenkkammer herangezogen.

Die Umschalt- und Mischeinrichtung wird hier zusätzlich separat beschrieben, weil auch andere Anwendungsfälle sinnvoll erscheinen, beispielsweise der Aufbau von Zwischenwänden in Gebäuden mit besonderem Zweck mit integrierter Umschalt- und Mischfunktion und direkt angeschlossenen raumlufttechnischen Anlagenteilen.

Eine konkrete raumlufttechnische Anlage, die eine Einbausituation für eine erfindungsgemäße Umschalt- und Mischeinrichtung ist, weist auf: zumindest einen ersten Hauptströmungsweg von einem Abluftanschluss zu einem Fortluftanschluss, einen zweiten Hauptströmungsweg von einem Außenluftanschluss zu einem Zuluftanschluss, ein beide Strömungswege umfassendes Gehäuse. Beispielsweise ist außerdem in dem Gehäuse zwischen den Hauptströmungswegen ein Trennflächen-Wärmeübertrager angeordnet.

Die oben genannten Luftanschlüsse sind dabei bevorzugt in einem offenen Luftende des Gehäuses angeordnet. Der Trennflächen-Wärmeübertrager ist nach dieser bevorzugten Einbausituation bezüglich einer gedachten Gehäusemittenquerachse in einem dem Luftende gegenüberliegenden, geschlossenen Umlenkende des Gehäuses angeordnet. Zwischen dem Luftende und dem Umlenkende kann die erfindungsgemäße Umschalt- und Mischeinrichtung zum Umschalten der Hauptströmungswege und / oder zum frühzeitigen Umlenken von Teilströmen und / oder zum Mischen von Luftströme angeordnet sein.

Ein rekuperatives Verfahren verwendet einen solchen oder nach den jeweiligen abhängigen Ansprüchen weitergebildeten raumlufttechnischen Aufbau. Mit dem erfindungsgemäßen Anordnen des zumindest einen Plattenwärmeübertragers abweichend von seinen bekannten Standardanordnungen ergibt sich der Vorteil, dass ein Gehäuse völlig neu konzipiert werden kann, da die sowieso notwendige Umlenkung im Plattenwärmeübertrager und als Umlenkung des Luftstroms zur Anschlussseite, dem Luftende, verwendet wird. Bei beiden erfindungsgemäßen Varianten kann je nach benötigter Kühlleistung durch das Schalten oder Regeln von Klappen, die Anpassung von bevorzugt in einem Sackende angeordneten Befeuchterstufen und eine integrierte Umschaltung zwischen direkter und indirekter Außenluftnutzung werden zu niedrige und zu hohe Feuchten in der Zuluft und eine sonst zusätzlich erforderliche Kältemaschine vermieden. Der spezifische Elektroenergiebedarf und auch sonstige Kosten können gesenkt werden.

Die Verwendung einer erfindungsgemäßen Umschalt- und Mischeinrichtung ist wirtschaftlich sinnvoll, weil mit ihr ein modularer Gehäuseaufbau vervollständigt werden kann und sie viele Freiheitsgrade bietet. Das Design als vertikal wie auch seitlich nach Wunsch durchlässiger Wandaufbau, mit integrierten Verbindungsströmungswegen in Breitenrichtung und Durchtrittströmungskanälen durch die kurze Tiefe der Wand, trägt die Umschalt- und Mischeinrichtung wegen Vermeidung von unnötigen Druckabfällen zur Leistungssteigerung der gesamten Anlage im Gehäuse oder einer sonstigen Einbausituation bei.

Zur Erläuterung der Vorteile der Umschalt- und Mischeinrichtung bei Verwendung in einer solchen raumlufttechnischen Anlage werden nachfolgend Schaltungsvarianten beschrieben.

Grundsätzlich kann jedoch die Außenluft als Wärmesenke zur Kühlung herangezogen werden, da die Außenluft im Jahresverlauf meistens kälter als beispielsweise 23 °C ist und in nur ca. 600 Stunden pro Jahr eine Kühlung bei Außenlufttemperaturen über 23 °C erforderlich wird. Es besteht im Prinzip entweder die Möglichkeit, die Außenluft ohne Umwege zu verwenden, also das Rechenzentrum direkt mit Außenluft zu belüften und damit zu kühlen, oder aber die Außenluft über einen Wärmeübertrager entkoppelt, also indirekt zur Kühlung zu nutzen. Die direkte Kühlung eines Rechenzentrums mit Außenluft ist von verschiedenen Bedingungen abhängig. Gelangt sie direkt in das Rechenzentrum, ist ihre Qualität für die Rechnertechnik von großer Bedeutung. Liegt standortbedingt belastete Außenluft vor, wird grundsätzlich von einer direkten Nutzung abgeraten. Dies trifft nahezu in alle Fällen der zu hohen oder zu niedrigen Feuchte der Außenluft zu, da die Feuchte im Jahres- und im Tagesverlauf stark schwankt.

Die direkte freie Kühlung hat den großen Vorteil, dass der Wärmewiderstand und der Druckabfall eines sonst notwendigen Wärmeübertragers nicht berücksichtigt werden muss. Sie hat aber auch den Nachteil, dass die Zuluft im Winter befeuchtet und im Sommer entfeuchtet werden muss, weil die Außenluftfeuchte im Jahresverlauf stark variiert.

In der Praxis werden häufig Grenzwerte für die absolute Feuchte der Zuluft von 4 bis 6 g/kg im Winter als unterer Grenzwert und 10 bis 12 g/kg im Sommer als oberer Grenzwert akzeptiert. Die Zuluft darf nicht zu trocken werden, da ansonsten elektrostatische Ladungseffekte zum Problem der IT-Systeme werden können, sie darf aber auch nicht zu feucht werden, da dann ebenfalls Probleme beispielsweise durch lokale Kondensation an den IT-Systemen entstehen können.

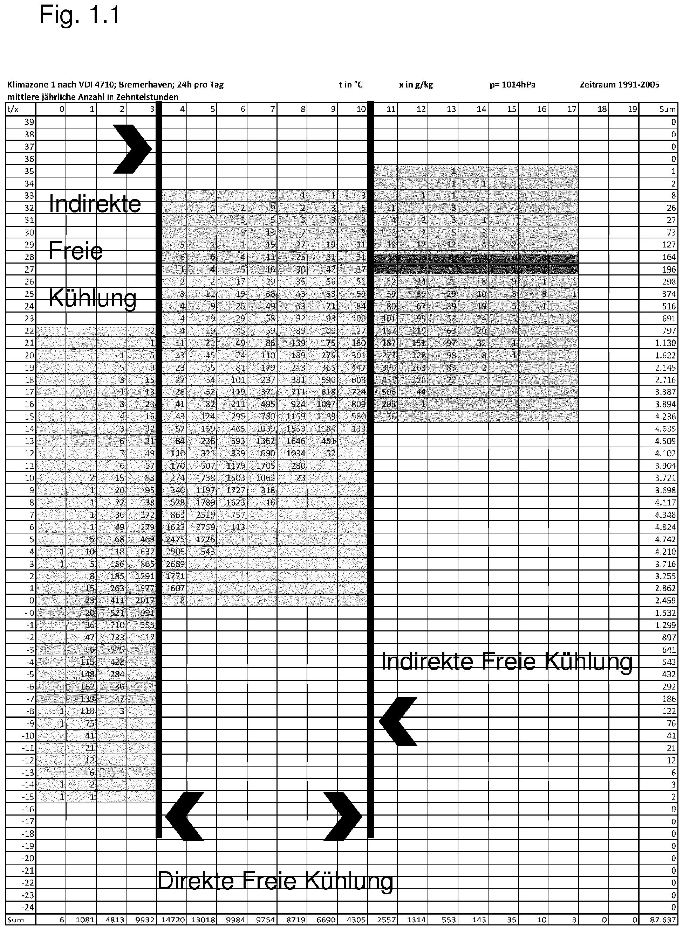

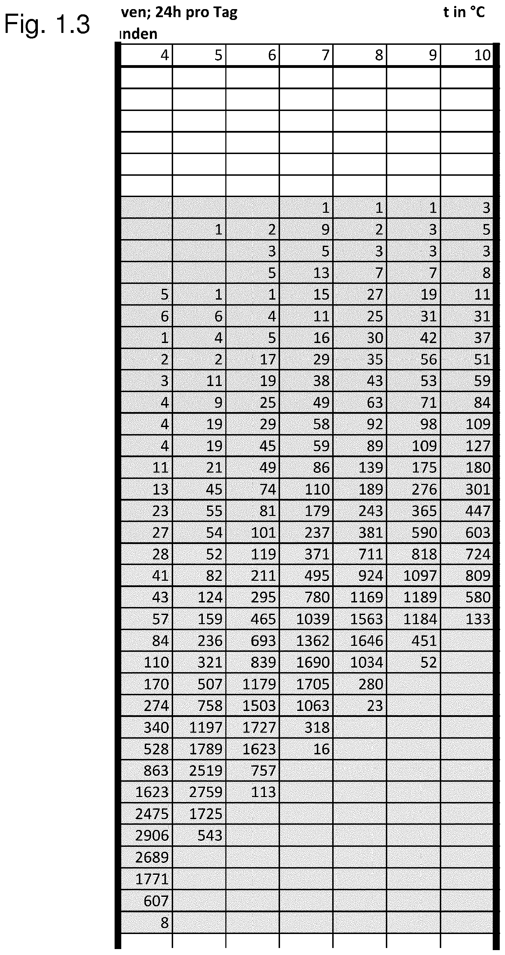

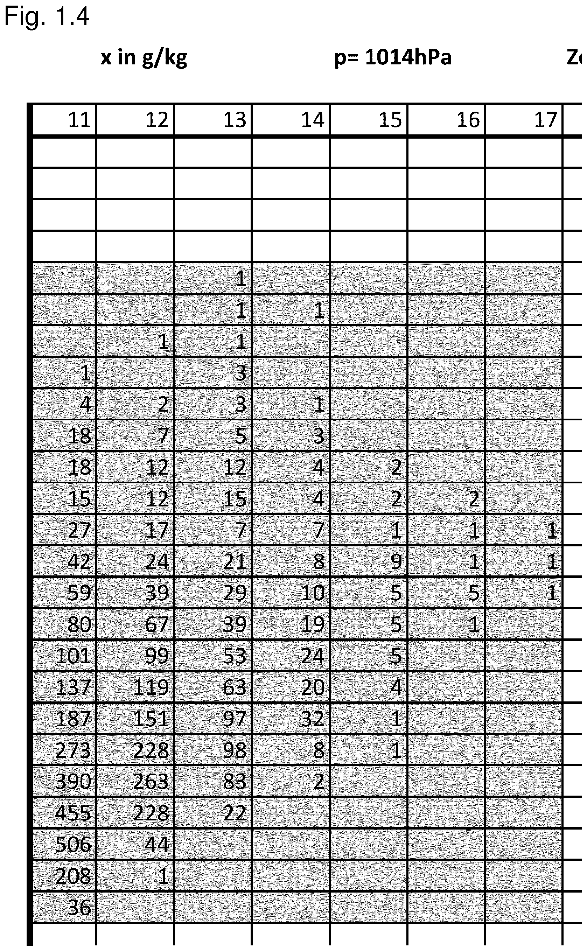

In den meisten Gebieten in Deutschland kann im Bereich zwischen 18 und 23 °C sowie zwischen 4 g/kg und 10 g/kg die Außenluft ohne eine Luftbehandlungsfunktion in ca. 600 h/a direkt verwendet werden (Figur 1.1 und Figur 1.3, mittlerer Wertebereich in der Tabelle).

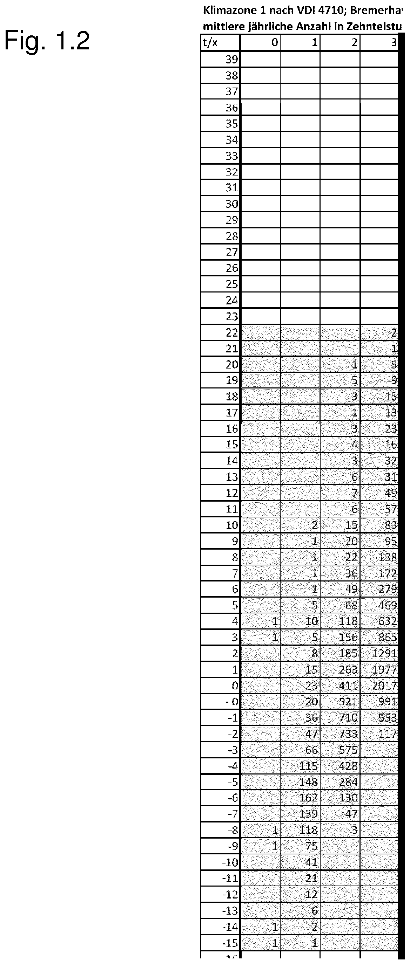

Unterhalb einer Außenlufttemperatur von 18 °C und einer absoluten Feuchte unter 4 g/kg wird in fast 1.600 h/a durch Nutzung der indirekten freien Kühlung und ohne zusätzliche thermodynamische Luftaufbereitung die geforderte Zulufttemperatur erreicht (siehe Tabelle in Figur 1.1 und Figur 1.2, linker Bereich, Spalten 2 bis 5).

Unterhalb von 18 °C und über 4 g/kg kann in mehr als 6.000 h/a die minimale Zulufttemperatur durch einfaches Mischen von Außenluft mit Abluft energetisch effizient gewährleistet werden, da keine Luftbehandlungsfunktionen erforderlich sind (Figur 1.1 und Figur 1.3, unterer mittlerer Wertebereich der Tabelle).

Im Bereich über 23 °C Außenluft und bis zu einer Außenluftfeuchte von 10 g/kg kann durch trockene, sensible Kühlung die geforderte Zulufttemperatur in ca. 120 h/a sichergestellt werden (Figur 1.1 und Figur 1.3, oberer mittlerer Bereich der Tabelle). Die notwendige Kühlung wird dann durch ein Rückkühlwerk (RKW) auf Basis eines Wärmeübertragers mit indirekter Verdunstungskühlung bereitgestellt.

Durch die Verwendung eines Rückkühlwerkes, das mit Außenluft betrieben wird, wird die Temperatur nach dem Rückkühlwerk je nach Außen- und Abluftluftkondition auf ca. 18 bis 24 °C reduziert, ohne dass eine zusätzliche Kältemaschine benötigt wird.

Wenn die Summenhäufigkeiten der einzelnen Betriebszustände (siehe Tabelle der Figur 1.1) addiert werden, so ergibt sich für die direkte freie Kühlung (violetter, grüner und beiger Bereich) eine Summenhäufigkeit von rund 4.200 h, also 48 % der Jahresnutzungszeit, während 4.562 h, also 52 % auf die indirekte Nutzung der Außenluft fallen (türkiser (links) und blauer (rechts) Bereich bei beispielsweise 4 g und 10 g als Feuchtegrenzwerte.

Nachfolgend ist die Erfindung anhand von Figuren näher erläutert. Es zeigen
Fig. 1 Tabelle Häufigkeit der Außenluftzustände nach VDI 4710 am Beispiel von Bremerhaven und beispielhafte Nutzung der Freien Kühlung, Angabe spezifischer Außenluftkonditionen während eines Jahres und deren Summenhäufigkeiten in 1/10 Stunden,
Fig. 2 eine erfindungsgemäße Umschalt- und Mischeinrichtung, eingebaut in eine raumlufttechnische Anlage nach einem ersten Ausführungsbeispiel, in zwei schematisierten Seitenansichten und einer schematisierten Draufsicht, wobei zeichnerisch Einblicke auf erfindungswesentliche Einzelheiten gewährt sind, die normalerweise verdeckt wären, und wobei mit Pfeilen die Strömungsverläufe der Luft entsprechend rekuperativer Verfahren, nämlich im Fall der freien Kühlung die Luftwege Außenluft zur Zuluft und Abluft zur Fortluft, eingezeichnet sind,
Fig. 3 die raumlufttechnische Anlage aus Figur 2 in analoger Darstellung für den Fall indirekte freie Kühlung mit Pfeilen für die Luftwege Außenluft Fortluft und Abluft Zuluft, wobei die Umschalt- und Mischeinrichtung in dieser Verfahrensvariante Luftströme umlenkt,
Fig. 4 eine schematische Seitenansicht auf eine die Umschalt- und Mischeinrichtung umfassende raumlufttechnische Anlage, in die ein Luftstrom eingezeichnet ist, welcher teilweise durch- und teilweise umgelenkt wird,
Fig. 5 eine schematische Draufsicht auf die Umschalt- und Mischeinrichtung der Figur 4 mit demselben Luftstromverlauf, wobei zusätzlich mit gestrichelten Pfeilen der Außenluftstrom eingetragen ist,
Fig. 6-13 perspektivische Ansichten auf eine Umschalt- und Mischeinrichtung in separater Darstellung.

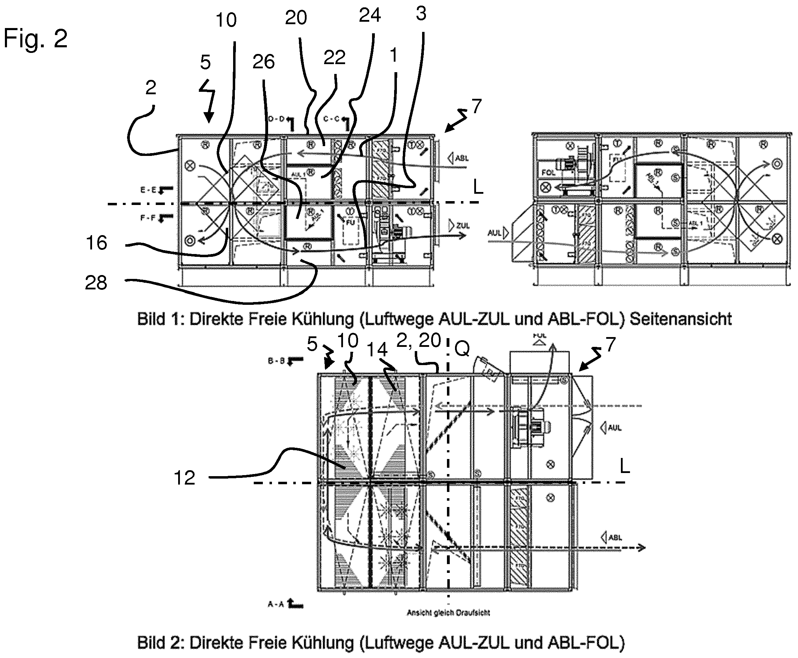

Um in dem oben beschriebenen Anwendungsfall "Einbau Umschalt- und Mischeinrichtung in eine raumlufttechnische Anlage" auf eine Kältemaschine verzichten zu können, ist eine Optimierung der Leistungsdaten (RKW und Verdunstungskühlung) zwingend erforderlich. Hierzu sind Wärmeübertrager 10 notwendig, die trockene Temperaturübertragungsgrade von mehr als 75 % erfordern. Gleichzeitig ist der Platzbedarf von benötigten und entsprechend großen Wärmeübertragern 10 enorm und daher schwer zu realisieren. Bild 1 und 2 der Figur 2 zeigen eine neuartige und platzsparende Lösungsmöglichkeit auf, bei der ein Plattenwärmeübertrager im Kreuz-Gegenstrom an einem geschlossenen Gehäuseende, dem Umlenkende 5, des Gerätes eingesetzt wird. In diesem Fall wird der Wärmeübertrager 10 gleichzeitig als Umlenkkammer für die beiden Luftströme Außenluft-Zuluft und Abluft-Fortluft verwendet.

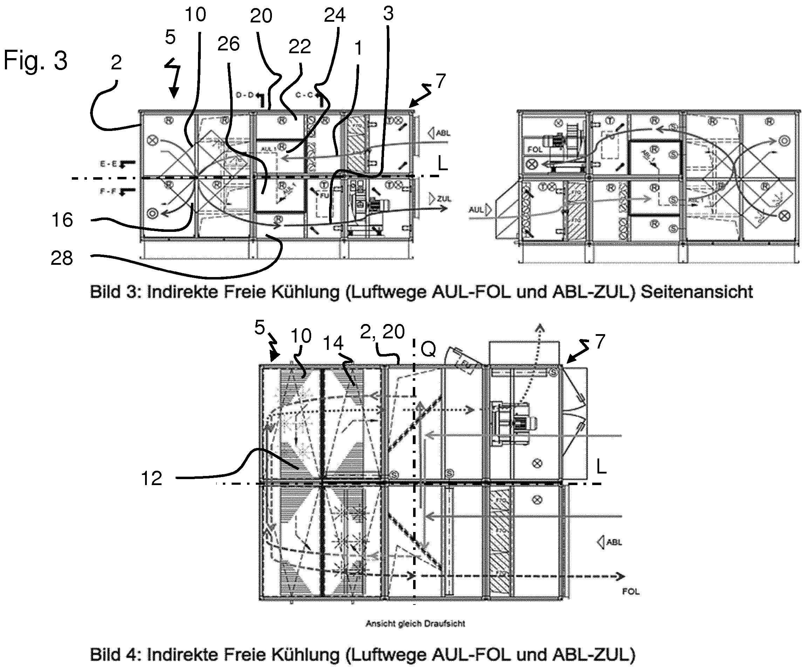

Mittels der vor dem Wärmeübertrager 10 in das kompakte Gehäuse 2 integrierten Umschalt- und Mischeinrichtung können die Lüftströme innerhalb des raumlufttechnischen Gerätes zwischen den beiden Strängen effizient umgeschaltet werden (siehe Figur 3, Bild 3 und 4). Hierdurch wird die Abluft mit der Zuluft zu einem Umluftsystem verbunden. Die Außenluft dient nun zum Betrieb des RKW, vorliegend einem Rückkühlwerk (RKW) auf Basis eines Wärmeübertragers 10 mit indirekter Verdunstungskühlung, das mit oder ohne Verdunstungskühlung betrieben werden kann. Wird der Wärmeübertrager nicht benötigt, kann der Plattenwärmeübertrager durch integrierte Bypassklappen umgangen werden.

Neben dem trockenen Temperaturübertragungsgrad des Wärmeübertragers spielt die Verdunstungskühlung eine weitere und entscheidende Rolle. Neben der bekannten einstufigen Befeuchtung wurde zur Steigerung des Befeuchtungsgrades eine zweite Befeuchterstufe eingesetzt, womit ein Befeuchtungsgrad von 1 erreicht wird. Der Wärmeübertrager 10 wird dann als Hybridsystem verwendet. Dabei wird der Wärmeübertrager 10 sowohl als Wärme- als auch als Stoffübertrager eingesetzt. Die indirekte Befeuchtung erfolgt somit nicht nur vor dem Wärmeübertrager 10, sondern auch direkt im Wärmeübertrager 10. Eine weitere Leistungssteigerung kann nur durch die Steigerung des Befeuchtungsgrades erfolgen. Hierzu wurde der Wärmeübertrager 10 so weiterentwickelt, dass eine besonders große Hydrophilie der Oberfläche erreicht wurde.

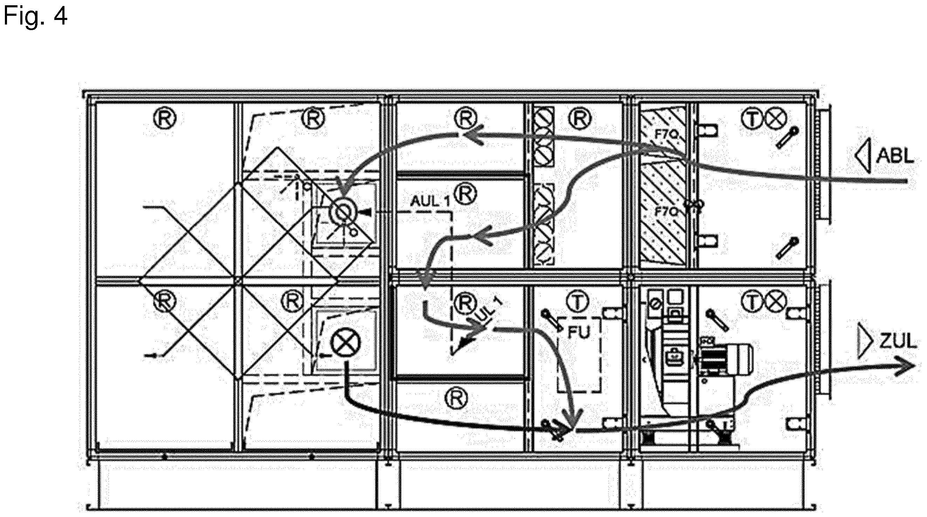

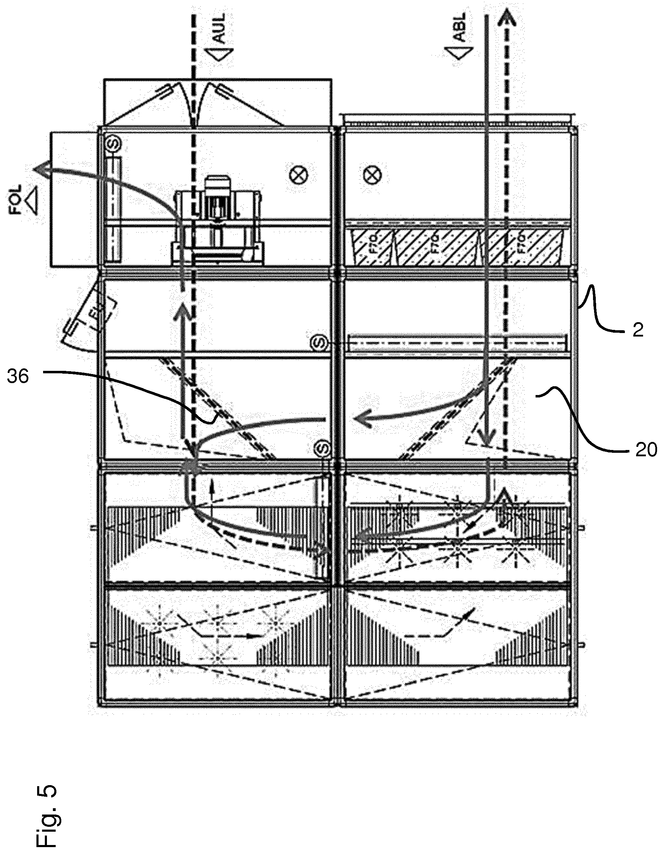

Die Umschalt- und Mischeinrichtung 20 ist mit weiteren Schaltungsvarianten in einer solchen raumlufttechnischen Anlage in den Figuren 4 und 5 dargestellt. Hier wird die Eignung für die Raumlufttechnik dadurch besonders deutlich, dass ein sonst erforderlicher dritter Verbindungsströmungsweg bei entsprechender Einstellung der Umschalt- und Mischeinrichtung überflüssig wird. Das gelingt durch die Verwendung des Wärmeübertragers 10 als Umlenkeinrichtung. Ein den zu mischenden Luftströmen, also der Umlenk- und Mischeinrichtung 20, zugewandter Raum des Wärmeübertragers kann bei erfindungsgemäßer Abstimmung der Öffnungen mit ggf. Klappen 32, 33, 35, 37 der Umschalt- und Mischeinrichtung zu Abmaßen des Wärmeübertragers 10 als eine Mischkammer genutzt werden, besonders bevorzugt auch als Befeuchtungskammer. Vorteilhafte erfindungsgemäße Wandungsgestaltungen 36 ermöglichen ein gezieltes Einströmen in solche Bereiche.

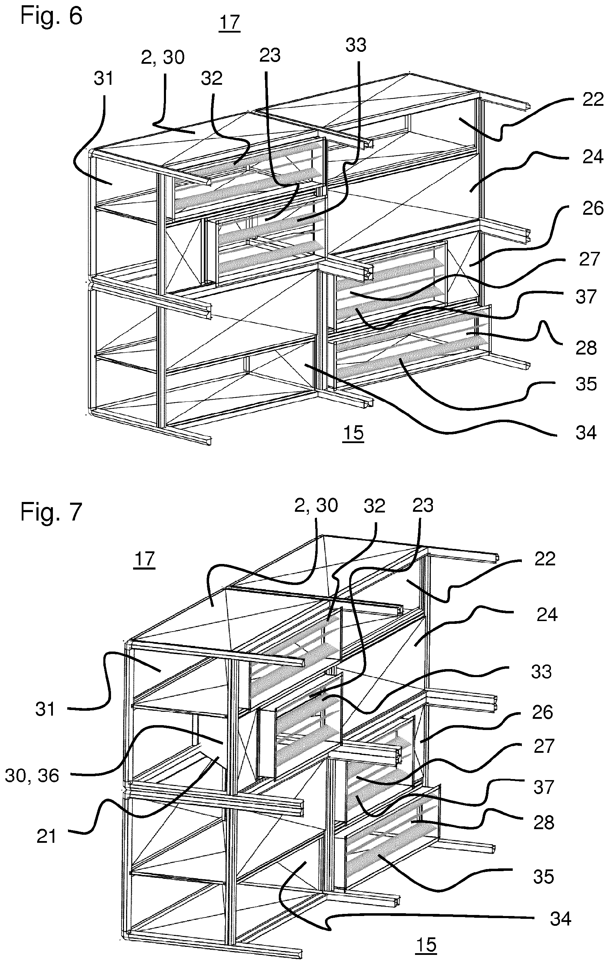

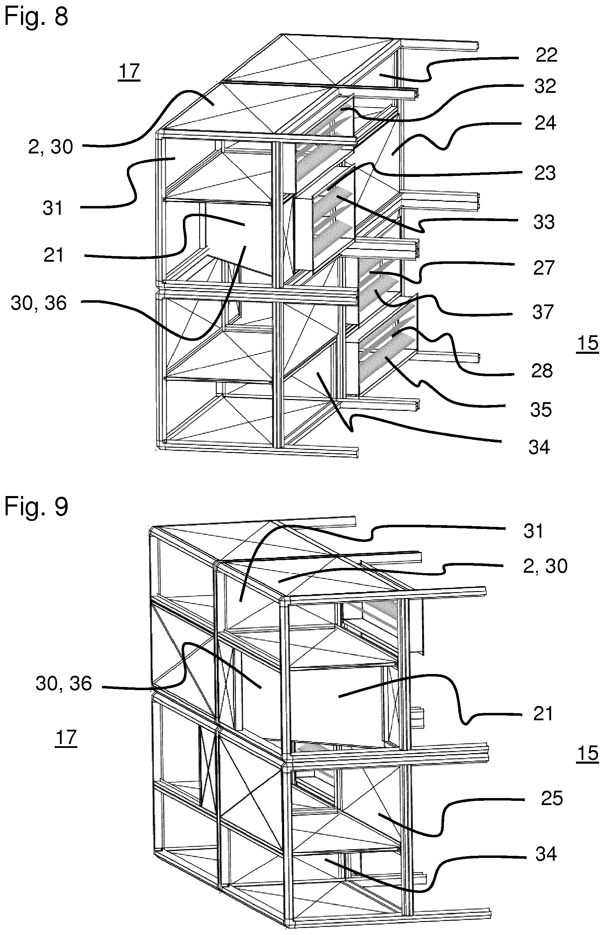

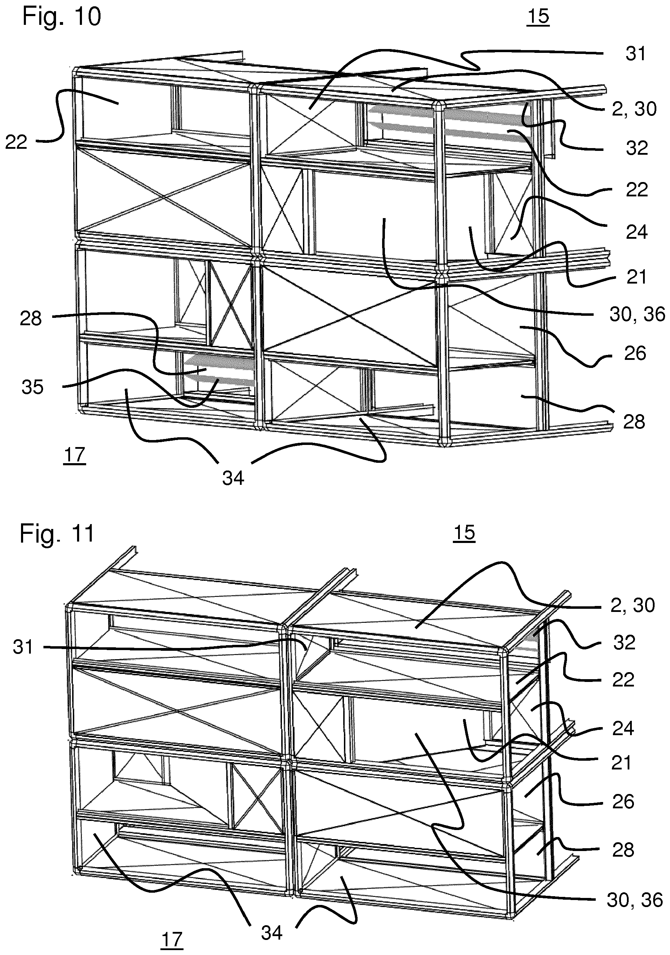

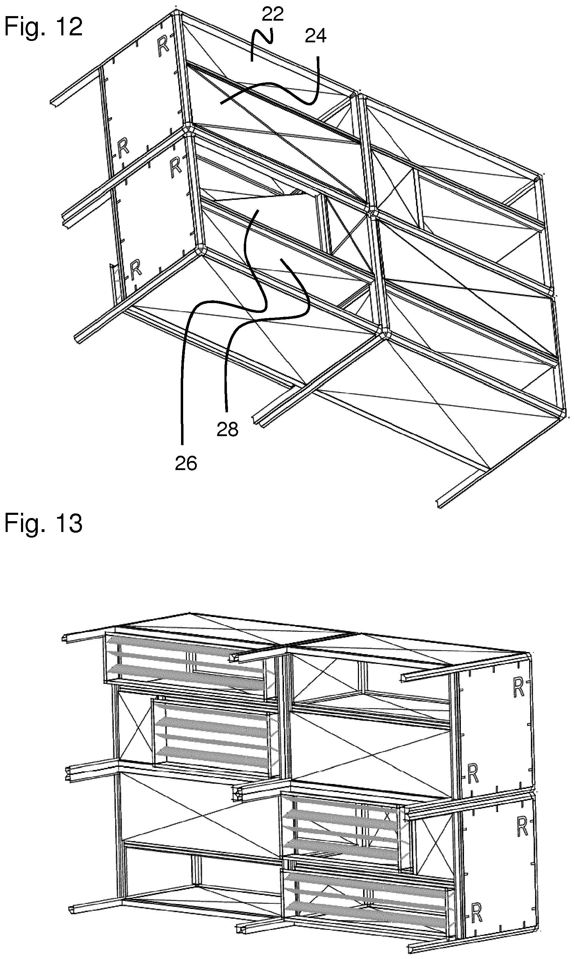

In separater Darstellung zeigen die Figuren 6 bis 13 die Umschalt- und Mischeinrichtung 20 in diversen perspektivischen Ansichten mit in Längsrichtung L zur Verdeutlichung der perspektivischen Ansicht herausragend dargestellten Streben auf der in dem obigen Anwendungsfall einer raumlufttechnischen Anlage dem Umlenkende 5 zugewandten Seite. Die seitlichen Außenwände, die in den Darstellungen teilweise weggelassen sind, um einen Einblick zu gewähren, sollte man sich als vollumfängliche Ummantelung des Gehäuses 2 vorstellen, da nach der dargestellten Ausführungsform der Gehäusequerschnitt des Gehäuses 2 vollständig durch die Umschalt- und Mischeinrichtung 20 ausgefüllt wird.

Die Umschalt- und Mischeinrichtung 20 der Figuren 6 bis 13 ist von oben nach unten gesehen in vier Etagen 22, 24, 26, 28 aufgeteilt. Eine oberste Etage 22 umfasst nebeneinander zwei rechteckige obere Durchtrittströmungskanäle 31. Darunter umfasst eine zweitoberste Etage 24 über einen Großteil ihrer Breite einen oberen Verbindungsströmungsweg 23 und zum verbleibenden Breitenanteil von etwas weniger als einem Viertel einen Einlass mit Klappe 37 in einen unteren Verbindungsströmungsweg 27. Der untere Verbindungsströmungsweg 27 erstreckt sich beinahe über die gesamte Breite einer zweituntersten Etage 26. Auf der untersten Etage 28 bleibt noch ein knappes Viertel der Gesamtbreite für einen Einlass mit Klappe 33 in den oberen Verbindungsströmungsweg 23. Insofern ist die Umschalt- und Mischeinrichtung 20 also vertikal durchlässig für Strömungswege, sodass neue Freiheitsgrade gewonnen sind, um Luftströme gezielt in bestimmte angeschlossene Anlagenkomponenten zuführen zu können.

Die Umschalt- und Mischeinrichtung 20 weist im in den Figuren 6 bis 13 dargestellten Ausführungsbeispiel zwei an die Hauptströmungswege 1, 3 angeschlossene Verbindungsströmungswege 23, 27 auf. Dazu sind die zweite und dritte Etage über zumindest einen großen Teil ihrer Breite als eine geteilte Doppelkanalführung ausgeführt, wobei sich ihre Strömungswege mittels der Umschalt- und Mischeinrichtung 20 kreuzen. Alternativ könnten im Rahmen der Erfindung auch auf andere Art zumindest zwei parallel zueinander geführte Umschaltkanäle als Verbindungsströmungswege in der wandartigen Umschalt- und Mischeinrichtung geführt sein.

Die Umschalt- und Mischeinrichtung 20 führt grundsätzlich ohne Umwege der gedachten Gehäuselängsrichtung L folgend voneinander getrennt die Außenluft der Abluft entgegen.

Im vorliegenden Ausführungsbeispiel der Figuren 6 bis 13 sind in die Umschalt- und Mischeinrichtung (20), nämlich in ihre Kanalwandungen 30, integrierte Klappen vorgesehen, welche Öffnungen der Umschalt- und Mischeinrichtungen vollständig oder teilweise zu verschließen bestimmt sind. Sie können alternativ auch an der Umschalt- und Mischeinrichtung (20) angeordnet sein, beispielsweise in einem angrenzenden Mischkammerbereich mit weiterer Anbindung an beispielsweise eine Teilung zwischen Wärmeübertragern. Mittels solcher Klappen können nach besonderen Klappenschaltungen und / oder Klappenregelungen ein Umgehen eines in den Hautströmungswegen 1, 3 geschalteten Wärmeübertragers 10 ermöglicht sein und die Hauptströmungswege 1, 3 umgeschaltet werden. So lassen sich den oben erwähnten Grundsatz brechend die Außenluft mit der Fortluft und die Abluft mit der Zuluft verbinden.

Die Umschalt- und Mischeinrichtung 20 weist nach dem dargestellten Ausführungsbeispiel nebeneinander in zwei Wandungsebenen angeordnet auf: eine erste Abluftklappe, ausgeführt als eine beispielsweise in Figur 6 dargestellte Klappe 32 des oberen Durchtrittströmungskanals 31, eine erste Außenluftklappe, beispielsweise in einer der mit R gekennzeichneten Seitenwandungen als Ausstellklappe ausgeführt, eine Fortluftklappe, beispielsweise ausgeführt als die Klappe 33 des oberen Verbindungsströmungskanals 23, eine Zuluftklappe, und / oder beispielsweise ausgeführt als die untere Klappe des Durchtrittströmungskanals 28. Dabei erstreckt sich die in den Figuren 4 und 5 dargestellte Ausführungsform der Umschalt- und Mischeinrichtung 20 über einen vollständigen Querschnitt des Gehäuses 2.

Sämtliche Verbindungsströmungswege 23, 27 sind mithin vollständig verschließbar. Quer zu deren eigentlichen Strömungsrichtungen, nämlich an den Verbindungsströmungswegen vorbei, sind die Durchtrittströmungskanäle 31, 34 ausgebildet, und zwar in der oberste 22 bzw. untersten 28 von den vier Etagen.

So ist nach einem Ausführungsbeispiel eines rekuperativen Verfahrens Außenluft als Teilstrom oder vollständig durch einen ersten der Verbindungsströmungswege 23 hindurch dem Wärmeübertrager 10, entlang der Längsachse L des Gehäuses 2 blickend, die Seiten wechselnd zuführbar, um in dem Wärmeübertrager 10 umgelenkt zu werden. Der erste Verbindungsströmungsweg 23 ist mit schräger Kanalwandung 36 derart ausgeformt, dass auf den Wärmetauscher 10 zu eine in der Blickrichtung entlang der Gehäuselängsachse L seitliche und höhenmäßige Umlenkung erfolgt. Die Umschalt- und Mischeinrichtung hat mit ihren strömungsgünstig geformten, dem Wärmeübertrager 10 zugewandten Auslässen eine Eigenschaft als Diffusor erfüllt. Die Strömungsverteilung in die zahlreichen Bereiche zwischen die Platten des Wärmeübertragers 10 gelingt je nach Wandungsneigung 36 besonders gut. In Figur 5 sind solche Geometrien als gestrichelte Linien in den Bereich der Etagen 24 und 26 eingetragen. In dem Eintrittsbereich des Wärmetauschers 10 ist nach einer besonderen Ausführungsform an der Umschalt- und Mischeinrichtung 20 eine

Befeuchtungseinrichtung für den Außenluftstrom und / oder den Abluftstrom angeordnet.

Die Umschalt- und Mischeinrichtung 20 ist nach einer vorteilhaften Ausführungsform derart eingerichtet, dass nach einem rekuperativen Verfahren Abluft teilweise in einen zweiten Verbindungsströmungsweg 27 und einen Durchleitungsströmungsweg, den Durchtrittströmungskanal 34, aufteilbar ist, sodass der im zweiten Verbindungsströmungsweg 27 die Seiten wechselnde Teilstrom der Abluft der Außenluft beigemischt wird, um gemeinsam den Wärmetauscher 10 einem der Hauptströmungswege 1, 3 folgend zu umgehen. Diverse Umlenkungen werden dabei mittels Wandungen 30 erzwungen. Eine gemeinsame Abströmung durch einen weiteren Durchleitungsströmungsweg erfolgt sodann zum Zuluftanschluss hin.

Ein erfindungsgemäßes Auslegungsverfahren einer raumlufttechnischen Anlage, insbesondere einer der vorab beschriebenen Anlagen sind in den Merkmalen zumindest einer Kanalwand 30 einer Umschalt- und Mischeinrichtung 20 derart ausgelegt, dass Druckverluste der beiden Hauptströmungswege 1, 3 annähernd gleich sind, wenn beide Hauptströmungswege annähernd gleich häufig benötigt werden, oder die Hauptströmungswege abweichende Druckverluste aufweisen, und zwar entsprechend abweichender Häufigkeiten.

### Bezugszeichenliste

- 1: erster Hauptströmungsweg
- 2: Gehäuse
- 3: zweiter Hauptströmungsweg
- 5: Umlenkende
- 7: Luftende

- 10: Wärmeübertrager
- 12: Strömungsseite
- 14: Strömungsseite
- 16: Breitseite

- 20: Umschalt- und Mischeinrichtung
- 21: Einlass oberer Verbindungsströmungsweg
- 22: oberste Etage
- 23: oberer Verbindungsströmungsweg
- 24: zweitoberste Etage
- 25: Einlass unterer Verbindungsströmungsweg
- 26: zweitunterste Etage
- 27: unterer Verbindungsströmungsweg
- 28: unterste Etage

- 30: Kanalwandungen
- 31: oberer Durchtrittströmungskanal
- 32: Klappe oberer Durchtrittströmungskanal
- 33: Klappe oberer Verbindungsströmungsweg
- 34: unterer Durchtrittströmungskanal
- 35: Klappe unterer Durchtrittströmungskanal
- 36: schräge Kanalwandung
- 37: Klappe unterer Verbindungsströmungsweg

- ABL: Abluftanschluss
- AUL: Außenluftanschluss
- FOL: Fortluftanschluss
- ZUL: Zuluftanschluss
- L: Längsachse
- Q: Mittenquerachse

## Patentansprüche

1. Umschalt- und Mischeinrichtung (20), insbesondere für eine raumlufttechnische Anlage, mit zumindest einem ersten Hauptströmungsweg (1) von einem Abluftanschluss (ABL) zu einem Fortluftanschluss (FOL), einem zweiten Hauptströmungsweg (3) von einem Außenluftanschluss (AUL) zu einem Zuluftanschluss (ZUL) und einem beide Strömungswege umfassenden Gehäuse (2), wobei die Umschalt- und Mischeinrichtung (20) zumindest zwei an die Hauptströmungswege angeschlossene Verbindungsströmungswege aufweist und dazu als eine geteilte Doppelkanalführung ausgeführt ist oder aus zumindest zwei parallel zueinander geführten Umschaltkanälen (20.1, 20.2) besteht, wobei in die Umschalt- und Mischeinrichtung (20) integriert oder an die Umschalt- und Mischeinrichtung (20) angeordnet Klappen angeordnet sind, mittels welcher Klappen nach besonderen Klappenschaltungen und/oder Klappenregelungen ein Umgehen eines in den Hauptströmungswegen (1, 3) geschalteten Wärmeübertragers (10) ermöglicht ist und die Hauptströmungswege (1, 3) umgeschaltet werden können, sodass die Außenluft mit der Fortluft und die Abluft mit der Zuluft verbunden werden, und wobei der Wärmeübertrager (10) ein Plattenwärmeübertrager im Kreuz-Gegenstrom ist, der an einem geschlossenen Gehäuseende, dem Umlenkende (5), der Umschalt- und Mischeinrichtung (20) eingesetzt ist und somit als Umlenkkammer für den ersten Hauptströmungsweg (1) und den zweiten Hauptströmungsweg (2) ausgebildet ist.

2. Umschalt- und Mischeinrichtung (20) nach Anspruch 1, **dadurch gekennzeichnet, dass** die Umschalt- und Mischeinrichtung (20) grundsätzlich voneinander getrennt die Außenluft der Abluft entgegenführt.

3. Umschalt- und Mischeinrichtung (20) nach einem der Ansprüche 1 oder 2, **dadurch gekennzeichnet, dass** die Klappen in oder an Kanalwandungen der Umschalt- und Mischeinrichtung (20) angeordnet sind.

4. Umschalt- und Mischeinrichtung (20) nach einem der vorangehenden Ansprüche, **dadurch gekennzeichnet, dass** die Umschalt- und Mischeinrichtung (20) und/oder eine die Umschalt- und Mischeinrichtung umschließende, an Abmaße einer raumlufttechnischen Anlage anzupassende Trennwand nebeneinander in zumindest einer Wandung angeordnet aufweist: eine erste Abluftklappe, eine erste Außenluftklappe, eine Fortluftklappe, eine Zuluftklappe, eine zweite Abluftklappe und/oder eine zweite Außenluftklappe.

5. Umschalt- und Mischeinrichtung (20) nach einem der vorangehenden Ansprüche, **dadurch gekennzeichnet, dass** sich die Umschalt- und Mischeinrichtung (20) über einen vollständigen Querschnitt des Gehäuses (2) erstreckt, bevorzugt in vertikaler Richtung aufgeteilt in vier Etagen (22, 24, 26, 28), von denen besonders bevorzugt die mittleren zwei Etagen die Verbindungsströmungswege aufweisen.

6. Umschalt- und Mischeinrichtung (20) nach einem der vorangehenden Ansprüche, **dadurch gekennzeichnet, dass** sämtliche Verbindungsströmungswege vollständig verschließbar sind und quer zu deren eigentlichen Strömungsrichtungen durch die Verbindungsströmungswege hindurch oder um die Verbindungsströmungswege herum Durchleitungsströmungswege ausgebildet sind, wobei bevorzugt eine oberste (22) und eine unterste (28) von vier Etagen die Durchleitungsströmungswege aufweisen.

7. Umschalt- und Mischeinrichtung (20) nach einem der vorangehenden Ansprüche, **dadurch gekennzeichnet dass** Außenluft als Teilstrom oder vollständig durch einen ersten der Verbindungsströmungswege hindurch dem Wärmeübertrager entlang einer Längsachse des Gehäuses (2) blickend die Seiten wechselnd zuführbar ist, um in dem Wärmeübertrager umgelenkt werden zu können, wobei der erste Verbindungsströmungsweg mit schrägen Wänden und/oder Stufen derart ausgeformt ist, dass auf den Wärmetauscher zu eine in der Blickrichtung entlang der Gehäuselängsachse seitliche und höhenmäßige Umlenkung erfolgt, wobei besonders bevorzugt in dem Eintrittsbereich des Wärmetauschers in die Umschalt- und Mischeinrichtung (20) integriert oder an der Umschalt- und Mischeinrichtung (20) angeordnet für den Außenluftstrom und/oder den Abluftstrom eine Befeuchtungseinrichtung ausgeführt ist.

8. Umschalt- und Mischeinrichtung (20) nach einem der vorangehenden Ansprüche, **dadurch gekennzeichnet, dass** Abluft teilweise in einen zweiten Verbindungsströmungsweg und einen Durchleitungsströmungsweg aufteilbar ist, sodass der im zweiten Verbindungsströmungsweg die Seiten wechselnde Teilstrom der Abluft der Außenluft beigemischt wird, um gemeinsam den Wärmetauscher einem der Hauptströmungswege folgend zu umgehen, während diverse Umlenkungen mittels Wandungen erzwungen werden, und dass besonders bevorzugt eine gemeinsame Abströmung durch einen weiteren Durchleitungsströmungsweg zum Zuluftanschluss hin erfolgt.

9. Auslegungsverfahren einer raumlufttechnischen Anlage mit einer Umschalt- und Mischeinrichtung (20) nach einem der vorangehenden Ansprüche, **dadurch gekennzeichnet, dass** in zumindest einer Kanalwand der Umschalt- und Mischeinrichtung (20) angeordnete Klappen derart ausgelegt sind, dass Druckverluste der beiden Hauptströmungswege (1, 3) annähernd gleich sind, wenn beide Hauptströmungswege annähernd gleich häufig benötigt werden, oder die Hauptströmungswege abweichende Druckverluste aufweisen, und zwar entsprechend abweichender Häufigkeiten.

10. Raumlufttechnische Anlage mit einer Umschalt- und Mischeinrichtung (20) nach einem der Ansprüche 1 bis 8, wobei die Umschalt- und Mischeinrichtung (20) bevorzugt als zumindest eine Umschaltbox mit zur Längsachse eines Trennflächen-Wärmeübertragers (10) parallel ausgerichteter Hauptströmungsrichtung (S) ausgeführt ist.

11. Raumlufttechnische Anlage mit zumindest einem ersten Hauptströmungsweg (1) von einem Abluftanschluss (ABL) zu einem Fortluftanschluss (FOL), einem zweiten Hauptströmungsweg (3) von einem Außenluftanschluss (AUL) zu einem Zuluftanschluss (ZUL), einem Gehäuse (2), insbesondere ausschließlich zwei Ventilatoren aufweisend, und einer Umschalt- und Mischeinrichtung (20) nach einem der Ansprüche 1 bis 8, die in einem Anlagenbereich zwischen dem Wärmeübertrager auf der einen Seite und den Luftanschüssen (ABL, FOL, AUL und ZUL) auf der anderen Seite angeordnet ist.

## Claims

1. A switching and mixing device (20), in particular for a ventilation-techology facility, with at least a first main flow path (1) from an exhaust connection (ABL) to an outgoing air connection (FOL), a second main flow path (3) from an outdoor air connection (AUL) to a supply air connection (ZUL), and a housing (2) that comprises both flow paths, wherein the switching and mixing device (20) has at least two connection flow paths connected to the main flow paths and is also designed as a split double duct guide or comprises at least two switching ducts (20.1, 20.2) routed in parallel to each other, wherein flaps are arranged integrated into the switching and mixing device (20) or arranged on the switching and mixing device (20), said flaps permitting bypassing of a heat exchanger (10) switched in the main flow paths (1, 3) based on special flap circuits and/or flap controls, and the main flow paths (1, 3) being switchable so that the outdoor air will be connected to the outgoing air and the exhaust air to the supply air, and wherein the heat exchanger (10) is a plate heat exchanger in cross-counterflow that is inserted at a closed housing end, the deflection end (5), of the switching and mixing device (20) and that is thus formed as deflection chamber for the first main flow path (1) and the second main flow path (2).

2. The switching and mixing device (20) in accordance with claim 1, **characterised in that** the switching and mixing device (20) generally leads the outdoor air opposite to the exhaust air separately from each other.

3. The switching and mixing device (20) in accordance with one of claims 1 or 2, **characterised in that** the flaps are arranged in or on duct walls of the switching and mixing device (20).

4. The switching and mixing device (20) according to one of the preceding claims, **characterised in that** the switching and mixing device (20) and/or a separating wall enclosing the switching and mixing device, to be adjusted to dimensions of a ventilation-technology facility, has the following arranged side by side in at least one wall: a first exhaust air flap, a first outdoor air flap, an outgoing air flap, a supply air flap, a second exhaust air flap and/or a second outdoor air flap.

5. The switching and mixing device (20) according to one of the preceding claims, **characterised in that** the switching and mixing device (20) extends across a full cross-section of the housing (2), preferably divided into four levels (22, 24, 26, 28) in the vertical direction, of which particularly preferably the two middle levels comprise the connection flow paths.

6. The switching and mixing device (20) according to one of the preceding claims, **characterised in that** all connection flow paths can be fully closed, and passage flow paths are formed crosswise to their actual flow directions through the connection flow paths or around the connection flow paths, wherein preferably a top-most (22) and a bottom-most (28) one of four levels comprise the passage flow paths.

7. The switching and mixing device (20) according to one of the preceding claims, **characterised in that** outdoor air can be supplied to the heat exchanger along a longitudinal axis of the housing (2) as a partial flow or completely, changing sides when viewed looking through a first one of the connection flow paths, in order to be deflectable in the heat exchanger, wherein the first connection flow path is formed with diagonal walls and/or levels so that a lateral and height-related deflection, viewed along the longitudinal housing axis, happens towards the heat exchanger, wherein particularly preferably the entrance area of the heat exchanger has a humidification device integrated into the switching and mixing device (20) or arranged on the switching and mixing device (20) for the outdoor air flow and/or the exhaust air flow.

8. The switching and mixing device (20) according to one of the preceding claims, **characterised in that** exhaust air can be partly divided into a second connection flow path and a passage flow path so that the partial flow of the exhaust air that changes sides in the second connection flow path is mixed into the outdoor air in order to bypass the heat exchanger together following one of the main flow paths, while various deflections are enforced by walls and that particularly preferably a joint downflow takes place through another passage flow path towards the supply air connection.

9. A design method of a ventilation-technology facility with a switching and mixing device (20) according to one of the preceding claims, **characterised in that** flaps arranged in at least one duct wall of the switching and mixing device (20) are designed so that pressure loss in the two main flow paths (1, 3) is virtually identical if both main flow paths are needed approximately at the same frequency, or the main flow paths have deviating pressure losses, specifically based on deviating frequencies.

10. A ventilation-technology facility with a switching and mixing device (20) according to one of claims 1 to 8, wherein the switching and mixing device (20) is preferably designed as at least one switching box with main flow direction (5) aligned in parallel with the longitudinal axis of a separating surface heat exchanger (10).

11. A ventilation-technology facility with at least a first main flow path (1) from an exhaust connection (ABL) to an outgoing air connection (FOL), a second main flow path (3) from an outdoor air connection (AUL) to a supply air connection (ZUL), a housing (2), in particular comprising exclusively two fans, and a switching and mixing device (20) in accordance with one of claims 1 to 8, arranged in a facility area between the heat exchanger on the one side and the air connections (ABL, FOL, AUL, and ZUL) on the other side.

## Revendications

1. Dispositif de commutation et de mélange (20), en particulier pour une installation destinée au conditionnement de l'air ambiant, avec au moins une première voie d'écoulement principale (1) d'un raccord d'air vicié (ABL) à un raccord d'air rejeté (FOL), une deuxième voie d'écoulement principale (3) d'un raccord d'air extérieur (AUL) à un raccord d'air frais (ZUL) et un boîtier (2) enveloppant les deux voies d'écoulement, le dispositif de commutation et de mélange (20) présentant au moins deux voies d'écoulement de jonction raccordées aux voies d'écoulement principales et étant réalisé à cet effet sous la forme d'un guidage à double canal divisé ou étant constitué d'au moins deux canaux de commutation (20.1, 20.2), des clapets étant intégrés dans le dispositif de commutation et de mélange (20) ou disposés sur le dispositif de commutation et de mélange (20), clapets au moyen desquels il est possible, selon des montages de clapets particuliers et / ou des régulations de clapets, de contourner un échangeur de chaleur (10) monté dans les voies d'écoulement principales (1, 3) et de commuter les voies d'écoulement principales (1, 3), de sorte que l'air extérieur est relié à l'air rejeté et l'air vicié à l'air frais, et dans lequel l'échangeur de chaleur (10) est un échangeur de chaleur à plaques à contre-courant croisé, qui est inséré à une extrémité fermée du boîtier, l'extrémité de déviation (5), du dispositif de commutation et de mélange (20) et est ainsi conçu comme chambre de déviation pour la première voie d'écoulement principale (1) et la deuxième voie d'écoulement principale (2).

2. Dispositif de commutation et de mélange (20) selon la revendication 1, **caractérisé en ce que** le dispositif de commutation et de mélange (20) achemine l'air extérieur et l'air vicié systématiquement de manière distincte en sens opposé.

3. Dispositif de commutation et de mélange (20) selon l'une des revendications 1 ou 2, **caractérisé en ce que** les clapets sont disposés dans ou sur des parois de canal du dispositif de commutation et de mélange (20).

4. Dispositif de commutation et de mélange (20) selon l'une des revendications précédentes, **caractérisé en ce que** le dispositif de commutation et de mélange (20) et / ou une paroi de séparation enveloppant le dispositif de commutation et de mélange, à adapter aux dimensions d'une installation destinée au conditionnement de l'air ambiant, présente, disposés les uns à côté des autres dans au moins une paroi : un premier clapet d'air vicié, un premier clapet d'air extérieur, un clapet d'air rejeté, un clapet d'air frais, un deuxième clapet d'air vicié et / ou un deuxième clapet d'air extérieur.

5. Dispositif de commutation et de mélange (20) selon l'une des revendications précédentes, **caractérisé en ce que** le dispositif de commutation et de mélange (20) s'étend sur une section transversale complète du boîtier (2), de préférence divisée dans le sens vertical en quatre étages (22, 24, 26, 28), dont les deux étages centraux comportent de manière particulièrement préférée les voies d'écoulement de jonction.

6. Dispositif de commutation et de mélange (20) selon l'une des revendications précédentes, **caractérisé en ce que** toutes les voies d'écoulement de jonction peuvent être complètement fermées et des voies d'écoulement de transmission sont formées transversalement à leurs directions d'écoulement proprement dites à travers les voies d'écoulement de jonction ou autour des voies d'écoulement de jonction, un étage supérieur (22) et un étage inférieur (28) de quatre étages comportant de préférence les voies d'écoulement de transmission.

7. Dispositif de commutation et de mélange (20) selon l'une des revendications précédentes, **caractérisé en ce que** de l'air extérieur peut être acheminé en alternant les côtés vers l'échangeur de chaleur en tant que courant partiel ou intégralement à travers un premier des voies d'écoulement de jonction en regardant le long d'un axe longitudinal du boîtier (2), afin de pouvoir être dévié dans l'échangeur de chaleur, la première voie d'écoulement de jonction étant formée avec des parois inclinées et / ou des gradins de sorte à produire une déviation latérale et en hauteur vers l'échangeur de chaleur dans le sens d'observation le long de l'axe longitudinal du boîtier, un dispositif d'humidification étant intégré de préférence en particulier dans la zone d'entrée de l'échangeur de chaleur dans le dispositif de commutation et de mélange (20) ou disposé sur le dispositif de commutation et de mélange (20) pour le courant d'air extérieur et / ou le courant d'air vicié.

8. Dispositif de commutation et de mélange (20) selon l'une des revendications précédentes, **caractérisé en ce que** l'air vicié peut être partiellement divisé en une deuxième voie d'écoulement de jonction et une voie d'écoulement de transmission, de sorte que le flux partiel de l'air vicié en alternance des côtés dans la deuxième voie d'écoulement de jonction est mélangé à l'air extérieur pour contourner ensemble l'échangeur de chaleur en suivant l'une des voies d'écoulement principales, tandis que différentes déviations sont forcées au moyen de parois, et **en ce que**, de préférence, en particulier un écoulement d'évacuation commun est effectué à travers une autre voie d'écoulement de transmission vers le raccord d'air frais.

9. Procédé de conception d'une installation destinée au conditionnement de l'air ambiant avec un dispositif de commutation et de mélange (20) selon l'une des revendications précédentes, **caractérisé en ce que** des clapets disposés dans au moins une paroi de canal du dispositif de commutation et de mélange (20) sont conçus de telle sorte que les pertes de pression des deux voies d'écoulement principales (1, 3) sont à peu près égales lorsque les deux voies d'écoulement principales sont requises à peu près à la même fréquence, ou que les voies d'écoulement principales présentent des pertes de pression divergentes, et ce en fonction de fréquences divergentes.

10. Installation destinée au conditionnement de l'air ambiant avec un dispositif de commutation et de mélange (20) selon l'une des revendications 1 à 8, le dispositif de commutation et de mélange (20) étant réalisé de préférence sous forme d'au moins un boîtier de commutation avec un sens d'écoulement principal (S) orienté parallèlement à l'axe longitudinal d'un échangeur de chaleur à surfaces de séparation (10).

11. Installation destinée au conditionnement de l'air ambiant avec au moins une première voie d'écoulement principale (1) d'un raccord d'air vicié (ABL) à un raccord d'air rejeté(FOL), une deuxième voie d'écoulement principale (3) d'un raccord d'air extérieur (AUL) à un raccord d'air frais (ZUL), un boîtier (2), comportant en particulier exclusivement deux ventilateurs, et un dispositif de commutation et de mélange (20) selon l'une des revendications 1 à 8, qui est disposé dans une zone de l'installation entre l'échangeur de chaleur d'un côté et les raccords d'air (ABL, FOL, AUL et ZUL) de l'autre côté.
